# EUROPEAN PATENT SPECIFICATION

(11) **EP 2 715 936 B1**
(45) Date of publication and mention of the grant of the patent: **22.03.2017**
(21) Application number: 11866317.8
(22) Date of filing: 24.05.2011
(51) Int. Cl.: H03G 3/10, H03G 3/02, H03G 5/16, H03G 5/02, G06F 3/048, H04M 1/247, H04S 7/00, H03G 5/04

(54) **AN APPARATUS WITH AN AUDIO EQUALIZER AND ASSOCIATED METHOD**
VORRICHTUNG MIT EINEM TONENTZERRER UND ZUGEHÖRIGES VERFAHREN
APPAREIL COMPORTANT UN ÉGALISEUR AUDIO ET PROCÉDÉ ASSOCIÉ

(43) Date of publication of application: 09.04.2014
(73) Proprietor: Nokia Technologies Oy, 02610 Espoo (FI)
(72) Inventor: SASSI, Antti, Heikki, Tapio, FIN-33960 Pirkkala (FI)
(74) Representative: Smith, Gary John
(86) International application number: PCT/IB2011/052259
(87) International publication number: WO 2012/160415

(56) References cited:
- EP-A1- 2 073 511
- WO-A1-2010/138309
- US-A1- 2003 009 247
- US-A1- 2003 035 555
- US-A1- 2004 146 170
- US-A1- 2006 079 975
- US-A1- 2007 078 551
- US-A1- 2007 226 607
- US-A1- 2008 019 531
- US-A1- 2009 290 725
- US-A1- 2009 290 725
- US-B1- 6 381 469
- US-B1- 6 490 359

## Description

### Technical Field

The present disclosure relates to the field of audio equalizers, associated methods and apparatus. Certain embodiments relate to a user interface for an audio equalizer which enables a user to select a predefined frequency response and volume using a single control. Certain disclosed example aspects/embodiments relate to portable electronic devices, in particular, so-called hand-portable electronic devices which may be handheld in use (although they may be placed in a cradle in use). Such hand-portable electronic devices include so-called Personal Digital Assistants (PDAs).

The portable electronic devices/apparatus according to one or more disclosed example aspects/embodiments may provide one or more audio/text/video communication functions (e.g. tele-communication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture function (e.g. using a (e.g. in-built) digital camera), and gaming functions.

### Background

Graphic equalizers for audio applications (or audio equalizers) allow a user to visualize and control the amplitude (gain) of specific frequency bands within an audio signal. Graphic equalizers typically consist of multiple audio amplifiers, each centred at a different frequency in the audio range and covering a particular bandwidth. The number of amplifiers and their bandwidth can vary from one equalizer to the next. For example, a simple car equalizer might have one bank of 5-10 amplifiers (frequency bands) for adjusting the playback characteristics. On the other hand, an equalizer for professional use may comprise 25-31 amplifiers (frequency bands) necessary for fast control of the frequency response. Such an equalizer may be called a 1/3-octave equalizer because the centre frequency of each amplifier is spaced one third of an octave from its nearest neighbours, with 3 amplifiers per octave. Equalizers with half as many amplifiers per octave (2/3-octave equalizers) are normally sufficient where less precise tone shaping is required.

The amplifiers in many graphic equalizers are slide potentiometers which are adjusted by sliding a control button up or down. The slide potentiometers are placed side-by-side with the lowest frequency band on the left and the highest frequency band on the right. In this way, the positions of the buttons appear to follow a graphical curve that represents the gain as a function of frequency for each channel (hence graphic equalizer).

Graphic equalizers are common in middle and high end sound systems for consumer use, and are found in practically all professional recording studios. More recently, however, graphic equalizer applications have also become available for use in fine- tuning sound on computers and portable electronic devices.

Despite their graphical appearance, graphic equalizers are not intuitive to the average consumer and usually require a degree of knowledge and experience before they can be used successfully to improve the quality of the audio output. For this reason, many consumers are unsure of how to use their graphic equalizer properly and can end up setting the amplification of each frequency band to a sub-optimal value. This results in a reduced sound quality. Some users even choose to ignore the equalizer altogether and therefore do not take advantage of the functionality it has to offer.

The listing or discussion of a prior-published document or any background in this specification should not necessarily be taken as an acknowledgement that the document or background is part of the state of the art or is common general knowledge. One or more aspects/embodiments of the present disclosure may or may not address one or more of the background issues.

US2003035555 discloses instructions for controlling a parametric equalizer. The instructions are configured to display a composite equalization curve, wherein the composite equalization curve is formed from at least a first frequency filter with a first centre frequency, a second frequency filter with a second centre frequency, and a third frequency filter with a third centre frequency. The instructions furthermore provide for allowing a dragging movement of the first centre frequency, the second centre frequency, and the third centre frequency.

US2007078551 discloses a sound effect adjustment system including an adjustment unit able to automatically adjust the play mode of a playback apparatus based on the file type or the file location of the music file stored in the memory unit. Therefore, the user can play the music file without worrying about adjustments of intensities of different audio frequencies.

US2003009247 discloses multiple audio processing profiles stored in a processing profile database such that specific combinations of processing parameters can be retrieved and used at a later time. Audio processing profiles are organized according to specific delivery bandwidths such that a sound engineer can quickly and efficiently encode audio signals for each of a number of distinct delivery media. Synchronized A/B switching during playback of various encoded audio signals allows the sound engineer to detect nuances in the sound characteristics of the various encoded audio signals.

WO2010138309 discloses apparatuses for carrying out dynamic equalization processing of an audio signal, and apparatuses for and methods of controlling such equalization processing of the audio signal to dynamically adjust the time-varying spectrum of an audio signal to more closely match a user specified target time-invariant perceived audio signal spectrum while preserving the original dynamic range of the audio signal. The dynamic equalization is according to a user-defined spectral profile specified by a control interface that allows a user to define, create, modify and/or apply the user-defined spectral profile.

US2007226607 discloses a visual display interface provided that comprises an associated display icon. The display icon is dragged across the visual display interface in a movement so as to cause the mixing of a plurality of media streams. The output is a new mix of the various media streams.

US2008019531 discloses an audio signal processing apparatus including an examining unit and a generating unit. The examining unit examines, in each frequency band and at each localization angle, volume of an audio signal of two or more channels. The generating unit generates, on the basis of the examination result supplied from the examining unit, display data for showing the volume value in each frequency band and at each localization angle on an area that displays a frequency and a localization angle.

US2009290725 discloses systems and methods in which correspondences with content or other media assets can be established such that a media player can automatically modify or adjust an equalizer setting based on information associated with the content or other media assets. The media player may automatically adjust one or more equalizer settings based on genre, artist, album, or the like. In some embodiments, metadata associated with content or other media assets can be analysed to determine normalized data thereby potentially grouping content into supersets. Based on the normalized data, the media player may automatically adjust equalizer settings for each superset or grouping of content. Correspondences with one or more accessories may be established such that the media player can automatically modify or adjust an equalizer setting based on the one or more accessories.

US6490359 discloses a method and apparatus for mixing audio signals. Each audio signal is digitized and then transformed into a predefined visual image, which is displayed in a three-dimensional space. Audio effects added to the audio signals are transformed into predefined visual effects images, which are also displayed in a three-dimensional space. Selected audio characteristics of the audio signal, such as frequency, amplitude, time and spatial placement, are correlated to selected visual characteristics of the visual image, such as size, location, texture, density and colour. Dynamic changes or adjustment to any one of these parameters, or parameters of the audio effect images, causes a corresponding change in the correlated parameter or audio effect.

### Summary

According to a first aspect, there is provided an apparatus according to claim 1.

Each predefined equalization function may define a particular frequency response in which the relative amplitudes of one or more frequency bandwidths are predefined to provide the respective predefined equalization function.

The user interface may comprise a position indicator for indicating the detected regional position to a user of the apparatus. The user interface may comprise a position indicator corresponding to the current audio output.

The position indicator may be configured to be positioned on the selection plane to enable selection of a particular equalization function and respective absolute amplitude. The apparatus may be configured to detect the size and/or shape of the position indicator and/or selection plane. The apparatus may be configured to control the absolute amplitude of the specific audio output based on the detected size and/or shape of the position indicator and/or selection plane. The reference position may be located at the centre of the selection plane. The selection plane may have a circular, square, rectangular, trapezoidal, tabular or arbitrary shape.

The reference position may correspond to one or more of the following: a default absolute amplitude, a previously selected absolute amplitude, and a minimum absolute amplitude.

At least one of the one or more regions may comprise an equalization indicator for indicating the corresponding predefined equalization function to a user of the apparatus. The equalization indicator may comprise a word associated with the corresponding predefined equalization function.

At least one of the one or more regions may comprise one or more sub-regions corresponding to respective predefined equalization functions. Each predefined equalization function may define a particular frequency response in which the relative amplitudes of one or more frequency bandwidths are predefined to provide the respective predefined equalization function. The amplitude of one frequency bandwidth relative to the other frequency bandwidths may vary in an incremental manner from one sub-region to the adjacent sub-region.

The apparatus may be configured to prevent the absolute amplitude from being increased beyond a predetermined safety limit. The predetermined safety limit may be determined according to the duration of usage within a particular time period. The predetermined safety limit may prevent damage to human hearing and/or damage to one or more components of the apparatus. The apparatus may comprise a dynamic range compressor. The dynamic range compressor may be configured to reduce the dynamic range of an audio signal to prevent the absolute amplitude from being increased beyond the predetermined safety limit.

The apparatus may be configured to enable a user of the apparatus to vary one or more of the following: the number of regions, the number of sub-regions, the number of frequency bandwidths associated with each equalization function, the relative amplitudes of the frequency bandwidths, the equalization indicators, the shape of the selection plane, and the absolute amplitude associated with the reference point.

The apparatus may be a touch-user interface, a mouse interface, or a wand interface (i.e. an interface for a wireless remote, such as an infrared remote).

According to a further aspect, there is provided a device or user interface comprising any apparatus described herein. The device may be one or more of the following: an electronic device, a portable electronic device, a portable telecommunications device, a mobile phone, a tablet computer, and a module or user interface for any of the aforementioned devices.

According to a further aspect, there is provided a method according to claim 14.
The steps of any method disclosed herein do not have to be performed in the exact order disclosed, unless explicitly stated or understood by the skilled person.

According to a further aspect, there is provided a computer program comprising computer code configured to perform any method described herein. The computer program may be stored on a non-transitory computer-readable memory medium.

The apparatus may comprise a processor configured to process the code of the computer program. The processor may be a microprocessor, including an Application Specific Integrated Circuit (ASIC). The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.

According to a further aspect, there is provided a computer program comprising computer code configured to perform any method described herein.

The above summary is intended to be merely exemplary and non-limiting.

### Brief Description of the Figures

A description is now given, by way of example only, with reference to the accompanying drawings, in which:-
Figure 1 a shows a stereotypical graphic equalizer configured for the audio playback of a pop track;
Figure 1b shows a stereotypical graphic equalizer configured for the audio playback of a rock track;
Figure 1c shows a stereotypical graphic equalizer configured for the audio playback of a classic track;
Figure 2a shows a simplified user interface for a graphic equalizer according to one embodiment;
Figure 2b shows a simplified user interface for a graphic equalizer according to another embodiment;
Figure 2c shows a simplified user interface for a graphic equalizer according to yet another embodiment;
Figure 3a shows a square adjustment plane for a graphic equalizer;
Figure 3b shows a rectangular adjustment plane for a graphic equalizer;
Figure 3c shows a trapezoidal adjustment plane for a graphic equalizer;
Figure 3d shows an arbitrary adjustment plane for a graphic equalizer;
Figure 4 shows a simplified user interface for a graphic equalizer according to yet another embodiment;
Figure 5 shows a simplified user interface for a graphic equalizer according to yet another embodiment;
Figure 6 shows a device comprising the apparatus described herein;
Figure 7 shows the key steps of the method described herein; and
Figure 8 shows a computer readable medium providing a computer program for carrying out the method described herein.

### Description of Specific Aspects/Embodiments

As mentioned in the background section, graphic equalizers are used to adjust the frequency response of an audio system. Frequency response is the measure of an output spectrum in response to an audio input signal, and can be affected by the electronics of the system. Frequency response curves are often used to indicate the accuracy of electronic systems.

When a system reproduces all desired input signals with no amplification or attenuation of a particular frequency band relative to the other frequency bands, the system is said to be "flat", or to have a flat frequency response. The acoustics of a room can also affect the frequency response. This is because the shape of the room, the construction of the walls, ceiling and floors, the materials used, and even the presence of people can all affect the absorption and reflection of sound waves. When earphones are used for audio playback, however, the room acoustics have little impact on the frequency response, and the electronic system (especially the earphones themselves) is usually the primary source of any reduction in sound quality. When a system or room produces an uneven frequency response, a graphic equalizer can be used to flatten the response to improve the quality of the sound.

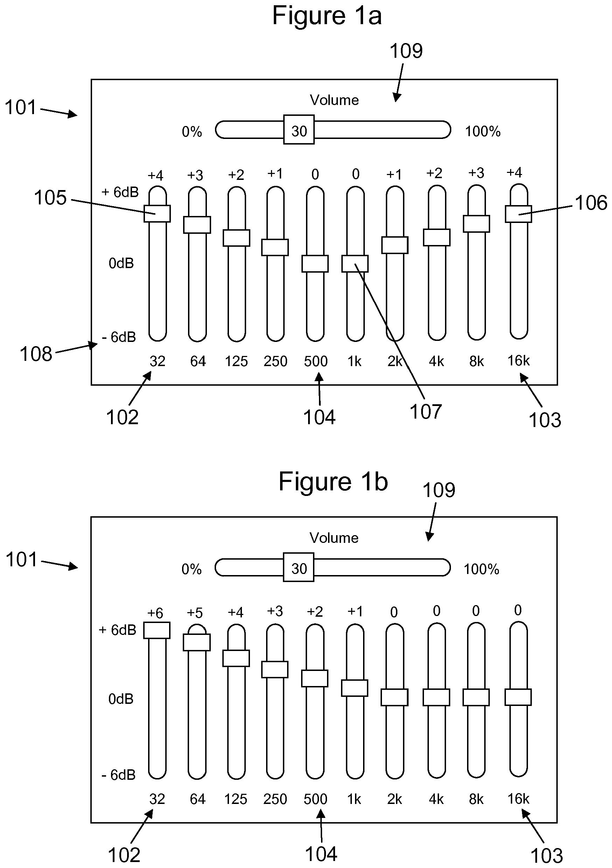

Instead of flattening the frequency response, graphic equalizers are sometimes also used to amplify and attenuate particular frequency bands to boost important sounds within an audio signal. This is illustrated in Figures 1a-1c.

For example, if a user of the audio equipment is listening to a pop track, the bass and the trebles are likely to play an equally important role in the overall sound. In this respect, the user may choose to adjust the amplifiers 105-107 of the graphic equalizer 101 to boost the low frequency 102 and high frequency 103 sounds relative to the mid-range frequencies 104 (Figure 1a). This is typically achieved by raising the low 105 and high frequency 106 potentiometers to increase the gain (+dB) of these frequencies, whilst leaving the mid-range potentiometers 107 at zero gain (0dB). In some cases, the user may even wish to apply a negative gain 108 (-dB) to the mid-range frequencies 104 to reduce their amplitudes further relative to the low 102 and high frequency 103 components. In general, the positions of the potentiometer control knobs should form a smooth wave pattern (i.e. a gradual and regular change in gain from one frequency band to the next). This is because the noise being amplified or attenuated usually spans more than one frequency in different strengths.

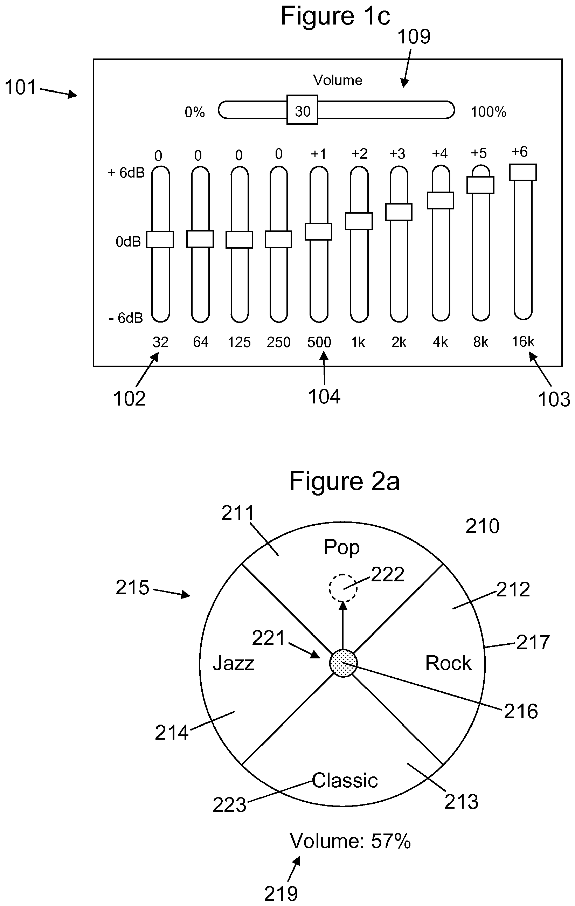

On the other hand, if the user is listening to a rock track, the bass is likely to be most important. Therefore, to achieve the best audio output with this track, the user may choose to adjust the amplifiers of the graphic equalizer 101 to boost the low frequency sounds 102 relative to the mid-range 104 and high frequencies 103 (Figure 1 b).

Similarly, if the user is listening to a classic track, he/she may choose to adjust the amplifiers to boost the high frequency sounds 103 relative to the low 102 and mid-range frequencies 104 so that the trebles become more pronounced within the overall audio output (Figure 1c).

One reason why users may wish to amplify and attenuate particular frequency bands is because one person's perception of sound characteristics can be different from another person's. In other words, the same audio output may sound different to different people.

As well as the relative amplitudes of the frequency bands, graphic equalizers 101 also allow the user to control the absolute amplitude of the audio output (i.e. the overall volume). This is usually achieved by incorporating a separate volume control 109 ranging from 0% to 100%. The minimum volume (0%) is often 0dB, whilst the maximum volume (100%) is limited by the mechanical and/or electronic components of the system. Whilst the above description refers to an analogue equalizer, the same (or similar) result can be achieved using a digital equalizer. In general, the principals of analogue and digital equalizers are very similar.

As mentioned previously, graphic equalizers are not intuitive to the average consumer and usually require a degree of knowledge and experience before they can be used successfully to improve the quality of the audio output. To alleviate this, some equalizers incorporate a number of "presets", which are basically preconfigured equalizer settings designed to provide a reasonable output for a particular type of music, such as pop, rock, classic, and jazz. Whilst the provision of presets can be useful, they rarely produce the optimum achievable sound, and often cannot be modified by the user. Furthermore, there are usually an insufficient number of different presets provided to cover the wide range of different sounds/genres likely to be encountered. In addition, the use of preset equalization functions does little to teach the user on how best to configure the equalizer, and if anything, makes the user less likely to try.

Another issue with the presets of existing graphic equalizers is that the text used to denote each preset can be misleading to a user. This is because certain words mean different things to different users, and as mentioned earlier, certain sounds may be perceived differently by different users. Therefore, for a particular user, a given preset may not produce the expected result. In this scenario, the user would likely want to select another preset, or adjust the equalizer settings manually (which is not necessarily straightforward to some users).

There will now be described an apparatus and method which may or may not address one or more of these issues. It should be noted, however, that the term "apparatus" as used throughout the specification may be taken to encompass one or more components of a device, a module for a device, or a device itself.

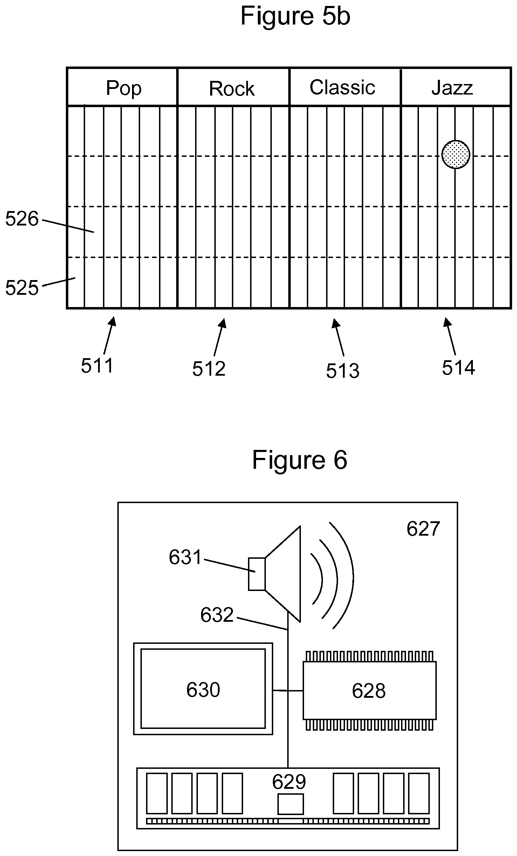

The apparatus (which will be described in detail later with reference to Figure 6) comprises an electronic display configured to present a user interface for a graphic equalizer which is arguably more accessible to inexperienced users.

One embodiment of the user interface 210 is illustrated schematically in Figure 2a, and comprises one or more predefined regions 211-214 corresponding to respective predefined equalization functions (or presets). Each predefined equalization function defines a particular frequency response in which the relative amplitudes of one or more frequency bandwidths are predefined. In the present example, there are 4 different predefined equalization functions suitable for use with pop, rock, classic, and jazz music, respectively.

In order to select a particular equalization function, the user interacts with the corresponding region 211-214 of the user interface 210, e.g. by touching the region (if the electronic display is a touch-sensitive display), or by moving a pointer over the region and clicking a button (using a mouse or a wireless remote/wand). The apparatus is configured to detect the position of the user input and apply the selected equalization function to an audio signal. The audio signal may be stored on the apparatus, playing on the apparatus, and/or may be controlled by the apparatus (and stored/playing elsewhere).

Unlike the user interfaces of existing equalizers, the present interface 210 allows a user to control the frequency response and overall volume (or absolute amplitude) of the audio output with a single user input, rather than having to adjust various frequency bands and a separate volume control, or having to rely on a limited number of ambiguous presets. In Figure 2a, the regions 211-214 are arranged to form a circular selection plane 215. When the user interacts with a particular point on the electronic display, the apparatus detects the position of the user input with respect to a reference point and sets the volume of the respective predefined equalization function based on the detected position. Furthermore, if the user is dissatisfied with the current output, he/she can simply interact with another region 211-214 of the user interface 210 to adjust the frequency response and overall volume.

In this embodiment, the reference point is located at the centre 216 of the selection plane 215, and corresponds to a minimum volume (0%). Therefore, the further the position of the user input from the centre 216 of the selection plane 215, the greater the volume. The maximum volume (100%) may correspond with a position on the circumference 217 of the circular selection plane 215 in this embodiment.

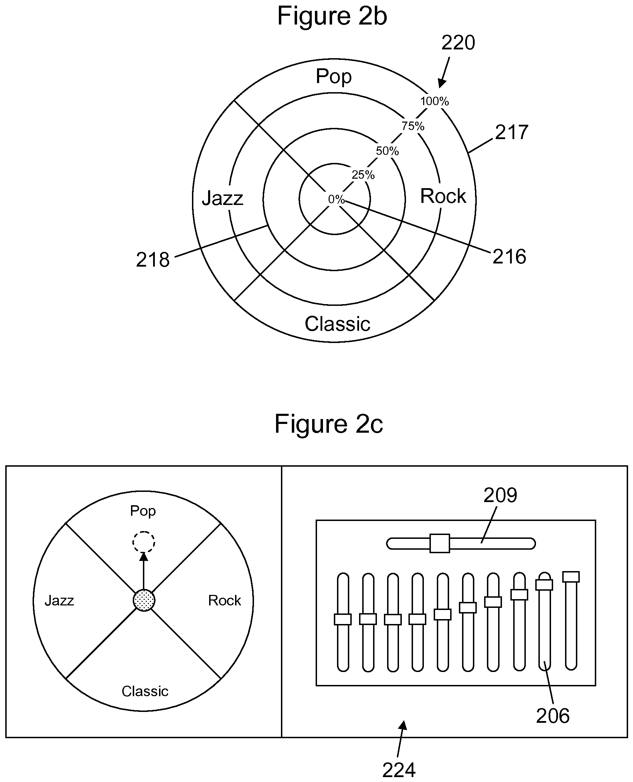

In other embodiments, the reference point may be located at different positions within the selection plane 215, and may correspond to a default volume or a previously selected volume. For example, as shown in Figure 2b, the reference point may be a circular line 218 located halfway between the centre 216 of the selection plane 215 and the circumference 217 (i.e. defining a smaller circle within the circular selection plane 215), and may correspond to a default volume of 50%. In this way, the volume may be decreased (<50%) if the user input is positioned closer to the centre 216 than the reference point, or increased (>50%) if the user input is positioned closer to the circumference 217 than the reference point.

Furthermore, the initial volume set by the apparatus (i.e. before the user has provided any input) may be the volume corresponding to the reference point, or may be a minimum volume, a default volume, or a previously selected volume. If the initial volume is a minimum volume, then the user may need to increase the volume in order to be able to hear the audio output. On the other hand, if the initial volume is a default volume or a previously selected volume, then this step may not be necessary. The use of a previously selected volume may be advantageous, however, as this is likely to be consistent with the user's preferred volume setting.

In the embodiment illustrated in Figure 2a, the user interface is configured to display the current volume setting (e.g. within a "pop-up" 219 or window inside or adjacent to the selection plane 215). In this way, the user is provided with a precise numerical value, which removes the need to estimate the volume by interpreting the position of the user input with respect to the reference point. This feature also makes the user aware of the initial volume setting (i.e. before the user has provided any input). In other embodiments, the user interface may additionally or alternatively be configured to display the currently selected equalization function within a pop-up 219 or window (not shown).

In the embodiment illustrated in Figure 2b, the user interface is configured to display a volume scale 220 on the selection plane 215 so that the user can estimate the current volume. The use of a volume scale 220 may be considered by some users to be less distracting than a pop-up 219 or window indicating the current volume setting, but may also be less accurate.

In order to help the user achieve the correct equalization settings, the user interface may comprise a position indicator 221 for indicating the position of the user input (and thus the current audio output). For example, if the user currently has the equalizer of Figure 2a set to "Pop" at 50% volume and is dissatisfied with the audio output, he/she will likely want to adjust the settings. However, without a position indicator 221, the user may be unsure about where to position his/her next input because the current position is not displayed. The position indicator 221 therefore serves as a benchmark for future adjustments to the volume and equalization function.

Throughout the figures of this specification the position indicator 221 is shown as a ball-like structure, but it could take many different forms. Furthermore, in some embodiments, the position indicator 221 may be displayed at all times while the user interface 210 is shown on the electronic display, whilst in other embodiments, the position indicator 221 may only appear once the user has provided a first user input. Also, in some embodiments, the user may have to drag the position indicator 221 from one position to another (e.g. by maintaining contact with a touch-sensitive display, or by pressing and holding a button on a mouse or wireless remote/wand whilst moving the mouse/remote) in order to provide the user input. In other embodiments, however, the user may simply be able to select a different position on the selection plane 215 using a touch-input, the mouse, or the remote, and the position indicator 221 will jump from the previous position to the new position. Figure 2a shows the position indicator being moved from the centre 216 of the selection plane 215 to a new position closer to the circumference 217 of the selection plane 215.

In some embodiments (not shown), the overall volume (absolute amplitude) of the audio output may be controlled by varying the size and/or shape of the position indicator 221, rather than by varying the location of the position indicator 221. For example, if the position indicator 221 has a circular shape, the user may increase or decrease the radius of the position indicator to increase or decrease the overall volume, respectively. This may be achieved using a multi-touch input on a touch-sensitive display, or by pressing a corresponding button or key on the display, mouse or remote. However, given that the position indicator 221 may be not be circular in shape, the overall volume may be adjusted by varying any (one or more) dimension of the position indicator 221. For example, if the position indicator is rectangular in shape, an increase or decrease in the length and/or width of the rectangle may be used to increase or decrease the overall volume, respectively. Additionally or alternatively, the overall volume of the audio output may be controlled by varying the size and/or shape of the selection plane 215 in the same way as described above for the position indicator 221. Furthermore, variations in the size and/or shape of the position indicator 221 and/or selection plane 215 may be used to vary the loudness of the audio output.

As can be seen in Figures 2a and 2b, one or more of the different regions 211-214 of the user interface 210 may comprise an equalization indicator 223 for indicating the corresponding equalization function to a user of the apparatus. The equalization indicator 223 typically comprises a word associated with the corresponding equalization function, and in the illustrated embodiments is simply a word denoting the genre of music that the equalization function is intended to be used with (i.e. pop, rock, classic, or jazz, etc). A disadvantage of this approach, however, is that some songs fall into multiple categories, resulting in the user being uncertain as to the most appropriate equalization function for use.

To alleviate this problem, some embodiments may comprise words which more accurately describe the sound effect likely to be achieved by applying a particular equalization function (such as "bright", "dark", "delicate", or "impressive", for example). In other embodiments, the equalization indicator 223 may comprise words which indicate the frequency bands which are likely to dominate the audio output when the equalization function is applied (such as "bass", "mid-range", or "treble", for example).

The equalization indicator 223 need not be limited to words, but may comprise letters, numbers, symbols/icons, and/or any other indication which may help the user to select the most suitable equalization function for a particular audio signal. Furthermore, the currently selected region 211-214 of user interface 210, or the corresponding equalization indicator 223, may be highlighted to indicate the selection.

In some embodiments, the equalization indicator 223 may comprise shading (e.g. greyscale) or colour coding. The shading or colour coding may be used to indicate the frequency response and/or the overall volume of the audio output. For example, the corresponding region 211-214 of the user interface 210, or even the whole of the user interface 210, may comprise a lightly shaded/coloured background (or border) when the trebles are being amplified over the bass and midrange frequencies. Likewise, the corresponding region 211-214 or user interface 210 may appear darker when the low frequency bands (bass) are being amplified over the midrange and treble frequencies. Similarly the shading/colouration could appear lighter or darker as the overall volume increases or decreases. Such shading/colour coding may be used together with, or instead of, any other indication to assist the user's selection.

As well as the equalization indicator 223, more experienced users of graphic equalizers may wish to see a graphical representation 224 of the frequency response as they select a particular equalization function. This feature allows users to check that what they have selected is consistent with what they intended to select. In some embodiments, the graphical representation 224 may comprise the amplifiers/potentiometers 206 of a conventional graphic equalizer (Figure 2c). As shown in the figure, the amplifiers/potentiometers 206 of the graphical representation 224 are positioned as they would be if a conventional equalizer was being used to achieve the same audio output. The graphical representation 224 may also comprise a representation of the standard volume control 209 common to conventional equalizers. As with the frequency range amplifiers 206, the volume control 209 of the graphical representation 224 may also adapt to suit the current equalizer settings. A further advantage of this feature is that it also allows inexperienced users of graphic equalizers to see how the settings of a conventional equalizer would be configured to achieve a particular sound.

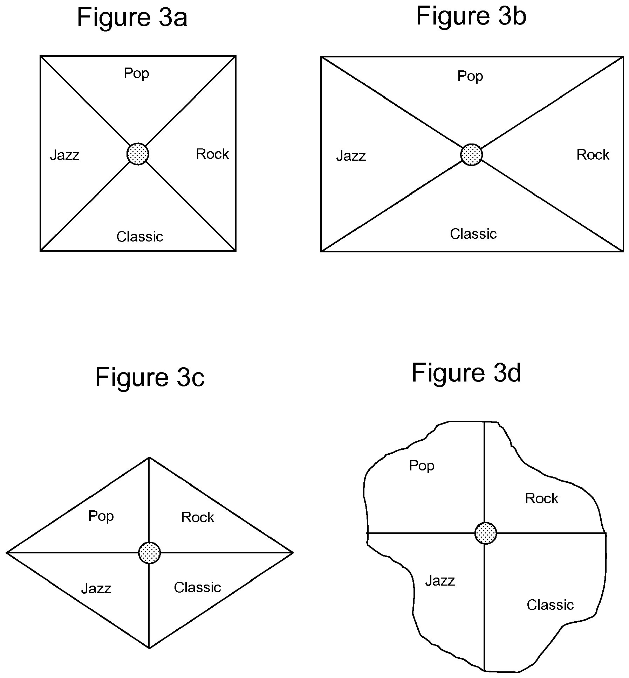

It should be noted, that whilst a circular selection plane is shown in Figures 2a-2c, other shapes of selection plane are also possible. For example, as illustrated in Figures 3a-3d, the selection plane may have a square (Figure 3a), rectangular (Figure 3b), trapezoidal (Figure 3c), or arbitrary (Figure 3d) shape.

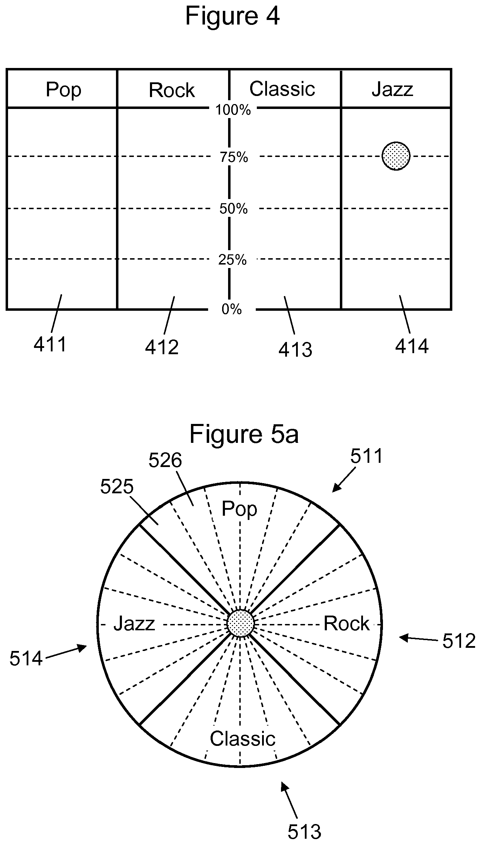

Figure 4 shows another embodiment in which the different regions 411-414 of the user interface are arranged in a tabular form. As with the previous embodiments, the user is able to select a particular equalization function and volume based on the position of a user input. In the example shown, the user has opted for a "jazz" function at 75% volume.

Figure 5 illustrates a further embodiment of the user interface. In this embodiment, at least one of the one or more regions 511-514 of the user interface comprises one or more sub-regions 525, 526 corresponding to respective predefined equalization functions. As with the other embodiments, each predefined equalization function defines a particular frequency response in which the relative amplitudes of one or more frequency bandwidths are predefined. However, the equalization functions associated with each sub-region 525, 526 in a given region 511-514 are configured to achieve a similar overall audio effect. For example, within the "pop" region 511 of Figure 5a, each sub-region 525, 526 is associated with an equalization function intended for use with a pop track. Likewise, within the "rock" region 512, each sub-region 525, 526 is associated with an equalization function intended for use with a rock track.

The different sub-regions 525, 526 within each region 511-514 of the user interface may be configured such that the frequency response varies gradually from one sub-region 525 to the next 526. This may be achieved by setting the frequency band amplifiers such that the amplitude of a particular frequency band relative to the other frequency bands varies in an (gradual) incremental manner from one sub-region 525 to the next adjacent sub-region 526. In this way, if the currently selected equalization function is good but not quite optimal at the current sub-region 525, the user can tweak the frequency response simply by selecting a neighbouring sub-region 526. A similar configuration is shown in Figure 5b for the tabular interface.

In some embodiments, the regions and sub-regions may be arranged such that the frequency response varies gradually from one region to the next. For example, if a user selects a sub-region within the "Pop" region which is closer to the "Rock" region than the "Jazz" region, then the resulting frequency response may have characteristics closer to "Rock" than "Jazz". Likewise, if a user selects a sub-region within the "Pop" region which is closer to the "Jazz" region than the "Rock" region, then the resulting frequency response may have characteristics closer to "Jazz" than "Rock".

Furthermore, in these embodiments the radial position (Figures 2a-2c and 5a) or vertical position (Figures 4 and 5b) of the user input may be used to vary the frequency response (i.e. relative amplitudes) rather than the overall volume (i.e. absolute amplitude) of the audio output. For example, as the user input is moved closer to the circumference of the circular interface (Figures 2a-2c and 5a) within the "Pop" region, the resulting frequency response may be varied to provide a different "Pop-like" sound (e.g. a more pronounced "Pop" effect) but without adopting audio characteristics of the neighbouring "Rock" or "Jazz" regions. In this scenario, a separate volume control may be used to set the absolute amplitude. The volume control may be a separate slider, or could be a character input region for inputting numerical values (possibly in response to a user prompt).

As a safety feature, the present apparatus may be configured to prevent the overall volume (absolute amplitude) from being increased beyond a predetermined safety limit. The predetermined safety limit may be set to prevent damage to human hearing and/or damage to one or more components (mechanical or electrical) of the apparatus. The volume considered to be "safe" for human ears varies depending the duration of exposure. For example, whilst the maximum volume may be limited to 91dB for 2 hours of exposure, this value may be reduced to 85dB if the duration is increased to 8 hours. In this respect, the predetermined safety limit may be set/calculated based on usage during a predetermined time period, or based on the average period of time that a user spends listening to music. Regarding damage to the equipment, the predetermined safety limit will depend on the specifications of the components. For example, if audio signals having an absolute amplitude greater than the maximum voltage of a loudspeaker are input (known as "clipping") a significant amount of heat can be generated in the electrical connections. This heat can melt the adhesive that holds the speaker together, or even destroy the enamel on the wire, causing the speaker to blow. In this case, the predetermined safety limit would be dictated by the maximum voltage of the loudspeaker. In some embodiments, the apparatus may comprise a dynamic range compressor configured to reduce the dynamic range of the audio signal to prevent the volume from being increased beyond the predetermined safety limit.

The apparatus may also be configured to enable a user of the apparatus to create his/her own equalization functions, or modify any predefined equalization functions. This allows the user to produce a series of equalization functions which best suit the different types of music (or other audio) that he/she normally listens to. In particular, the apparatus may be configured to enable the user to vary the number of regions and sub-regions (and therefore the number of different equalization functions), the number of frequency bands associated with each equalization function, and the relative amplitudes of the frequency bands. The apparatus may also be configured to enable the user to modify various cosmetic and/or functional features of the user interface to suit his/her personal preferences, such as the equalization indicators, the shape of the selection plane, and the absolute amplitude (volume) associated with the reference point.

Any settings which are configurable by the user may be adjusted using an on-screen control panel (not shown). Furthermore, such settings may be individually adjusted, or may be adjusted together as part of a larger "theme" or stylesheet that can be applied to the apparatus as a whole (e.g. along with wallpapers, widget colours, profile, and so on).

Greater detail of the apparatus 627 will now be provided with reference to Figure 6. The apparatus 627 comprises a processor 628, a storage medium 629, an electronic display 630, and a loudspeaker 631, which are electrically connected to one another by a data bus 632. The apparatus 627 may be an electronic device, a portable electronic device, a portable telecommunications device, a smartphone, a tablet computer, or a module for any of the aforementioned devices. In other embodiments, the apparatus may not comprise the display 630 and loudspeaker 631.

The processor 628 is configured for general operation of the apparatus 627 by providing signalling to, and receiving signalling from, the other device components to manage their operation. In particular, the processor 628 is configured to detect the position of a user input with respect to the reference point on a region of the user interface, and control the absolute amplitude of the equalization function associated with that region based on the detected regional position. In certain embodiments, the processor 628 may be a microprocessor, including an Application Specific Integrated Circuit (ASIC).

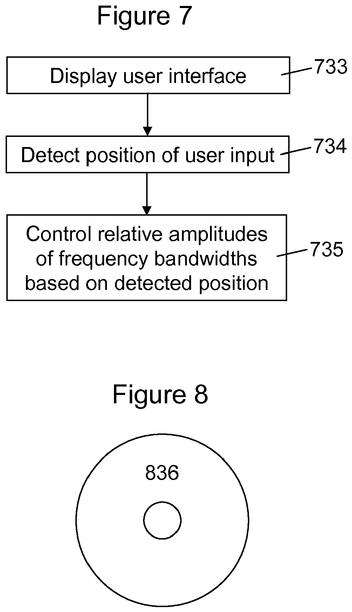

The storage medium 629 is configured to store computer code configured to perform, control or enable operation of the apparatus 627, as described with reference to Figure 8. The storage medium 629 may also be configured to store the user interface which enables a user to operate/control the graphic equalizer. In some embodiments, the user interface may be configured to enable the user to set/adjust any user-configurable equalizer settings via an on-screen control panel. In addition, the storage medium 629 may be configured to store one or more predefined equalization functions, and may also be configured to store audio data, including mp3 files (although they could be stored remotely). Furthermore, the storage medium 629 may be configured to store settings for the other device components. When the storage medium 629 is used to store settings for the other device components, the processor 628 may access the storage medium 629 to retrieve the settings in order to manage operation of the other device components.

The storage medium 629 may be a temporary storage medium such as a volatile random access memory. On the other hand, the storage medium 629 may be a permanent storage medium such as a hard disk drive, a flash memory, or a non-volatile random access memory.

The electronic display 630 is configured to display the user interface of the graphic equalizer, and receive user input for control of the graphic equalizer. The electronic display 630 may be a touch-sensitive electronic display configured to receive touch input from a user, or may be configured to receive user input via a mouse or wireless remote (e.g. an infrared remote/wand).

When the electronic display 630 is a touch-sensitive display, it may comprise an organic LED, inorganic LED, electrochromic, electrophoretic, or electrowetting display, and may incorporate one or more of the following technologies: resistive, side acoustic wave, capacitive, force panel, optical imaging, dispersive signal, acoustic pulse recognition, and bidirectional screen technology. The touch-sensitive display may be configured to detect physical contact with any part of the user's body (not just the user's fingers), and/or may be configured to detect physical contact with a stylus.

The loudspeaker 631 is configured to convert stored/received audio data (including mp3 files) into sound which is audible to the user. The term "loudspeaker" may be taken to mean one or more loudspeakers (including those incorporated in headsets). When the apparatus comprises multiple loudspeakers 631, they may be of different sizes configured for playback of different respective frequencies. For example, the multiple loudspeakers 631 may comprise one or more sub-woofers, woofers, mid-range drivers, and tweeters.

The main steps 733-735 of the method described herein are illustrated schematically in Figure 7.

Figure 8 illustrates schematically a non-transitory computer/processor readable medium 836 providing a computer program according to one embodiment. In this example, the computer/processor readable medium 836 is a disc such as a digital versatile disc (DVD) or a compact disc (CD). In other embodiments, the computer/processor readable medium 836 may be any medium that has been programmed in such a way as to carry out an inventive function. The computer/processor readable medium 836 may be a removable memory device such as a memory stick or memory card (SD, mini SD or micro SD).

The computer program may comprise computer code configured to perform, control or enable one or both of the following method steps: detecting the position of a user input, with respect to a reference position, on a region of a user interface, the user interface comprising one or more predefined regions corresponding to respective predefined equalization functions; and controlling the absolute amplitude of the respective predefined equalization function based on the detected regional position.

It will be appreciated that the equalization function described herein may be associated with an audio signal which accompanies video content.

The graphic equalizer described herein (including the user interface and the above-mentioned computer program) may be provided/available as a downloadable application (or "app"), and installed on any apparatus comprising the components illustrated in Figure 6.

Other embodiments depicted in the figures have been provided with reference numerals that correspond to similar features of earlier described embodiments. For example, feature number 1 can also correspond to numbers 101, 201, 301 etc. These numbered features may appear in the figures but may not have been directly referred to within the description of these particular embodiments. These have still been provided in the figures to aid understanding of the further embodiments, particularly in relation to the features of similar earlier described embodiments.

It will be appreciated to the skilled reader that any mentioned apparatus/device/server and/or other features of particular mentioned apparatus/device/server may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some embodiments, a particular mentioned apparatus/device/server may be pre-programmed with the appropriate software to carry out desired operations, and wherein the appropriate software can be enabled for use by a user downloading a "key", for example, to unlock/enable the software and its associated functionality. Advantages associated with such embodiments can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).

It will be appreciated that any "computer" described herein can comprise a collection of one or more individual processors/processing elements that may or may not be located on the same circuit board, or the same region/position of a circuit board or even the same device. In some embodiments one or more of any mentioned processors may be distributed over a plurality of devices. The same or different processor/processing elements may perform one or more functions described herein.

It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/embodiments may consist of any such individual feature or combination of features. In view of the foregoing description it will be evident to a person skilled in the art that various modifications may be made within the scope of the disclosure.

While there have been shown and described and pointed out fundamental novel features as applied to different embodiments thereof, it will be understood that various omissions and substitutions and changes in the form and details of the devices and methods described may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or embodiment may be incorporated in any other disclosed or described or suggested form or embodiment as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical side to secure wooden parts together, whereas a screw employs a helical side, in the environment of fastening wooden parts, a nail and a screw may be equivalent structures.

## Claims

1. An apparatus comprising:
an electronic display (630) configured to display a user interface (210) for an audio equalizer, the user interface (210) comprising one or more predefined regions (211, 212, 213, 214), the one or more predefined regions arranged to form a selection plane (215) and each region (211, 212, 213, 214) associated with a category of audio equalization;
the apparatus further comprising one or more processors (628) configured to:
detect a position of a user input within the one or more predefined regions relative to a reference point; and
control an amplitude of one or more frequency bandwidths and absolute amplitude of an audio signal based on the detected position of the user input within the one or more predefined region relative to the reference point to produce an audio output having audio characteristics associated with the category of audio equalization.

2. The apparatus of claim 1, wherein the user interface (210) is configured such that the audio characteristics of the audio output vary in a continuous manner as the detected position is continuously varied.

3. The apparatus of claim 1 or 2, wherein the user interface (210) is configured such that the audio characteristics of the audio output vary in a discrete stepwise manner as the detected position is continuously varied.

4. The apparatus of any preceding claim, wherein the one or more predefined regions comprises a plurality of predefined regions (211, 212, 213, 214) associated with respective categories of audio equalization.

5. The apparatus of claim 4, wherein the plurality of predefined regions (211, 212, 213, 214) are arranged such that the audio characteristics associated with the respective categories of audio equalization vary incrementally from one predefined region to another predefined region.

6. The apparatus of any preceding claim, wherein the user interface (210) comprises a position indicator (221) for indicating at least one of: the detected position and the absolute amplitude of the audio signal.

7. The apparatus of claim 6, wherein the position indicator (221) is configured to be positioned on the selection plane (215) to enable control of the audio output.

8. The apparatus of claim 6 or 7, wherein the apparatus is configured to detect a size and/or shape of the position indicator (221), and control the absolute amplitude of the audio output based on the detected size and/or shape of the position indicator (221).

9. The apparatus of claim 6 or 7, wherein the apparatus is configured to detect the selection plane (215), and control the audio output based on the detected selection plane (215).

10. The apparatus of claim 6, wherein the reference position corresponds to one or more of the following: a default amplitude, a previously selected amplitude, and a minimum amplitude.

11. The apparatus of any preceding claim, wherein the one or more predefined regions (211, 212, 213, 214) comprises an audio indicator (223) for indicating the associated category of audio equalization.

12. The apparatus of any preceding claim, wherein the one or more predefined regions (211, 212, 213, 214) comprises one or more predefined sub-regions (525, 526) defining respective audio outputs in which the amplitude of one or more frequency bandwidths of the audio signal are predefined.

13. The apparatus of any preceding claim, wherein the apparatus is configured to prevent the absolute amplitude of the audio signal from being increased beyond a predetermined safety limit.

14. A method comprising:
displaying a user interface for an audio equalizer, the user interface comprising one or more predefined regions (211, 212, 213, 214), the one or more predefined regions arranged to form a selection plane (215) and each region (211, 212, 213, 214) associated with a category of audio equalization;
detecting a position of a user input within the one or more predefined regions (211, 212, 213, 214) relative to a reference point; and
controlling an amplitude of one or more frequency bandwidths and absolute amplitude of an audio signal based on the detected position of the user input within the one or more predefined regions relative to the reference point to produce an audio output having audio characteristics associated with the category of audio equalization.

## Patentansprüche

1. Vorrichtung, umfassend:
ein elektronisches Display (630), das so ausgelegt ist, dass es eine Benutzerschnittstelle (210) für einen Tonentzerrer darstellt, wobei die Benutzerschnittstelle (210) eine oder mehrere vordefinierte Regionen (211, 212, 213, 214) umfasst, die eine oder die mehreren vordefinierten Regionen so angeordnet sind, dass sie eine Auswahlebene (215) bilden, und jede Region (211, 212, 213, 214) mit einer Tonentzerrungskategorie assoziiert ist;
wobei die Vorrichtung ferner einen oder mehrere Prozessoren (628) umfasst, die ausgelegt sind zum:
Erkennen einer Position einer Benutzereingabe innerhalb der einen oder der mehreren vordefinierten Regionen bezüglich eines Bezugspunkts; und
Steuern einer Amplitude einer oder mehrerer Frequenzbandbreiten und einer absoluten Amplitude eines Tonsignals basierend auf der erkannten Position der Benutzereingabe innerhalb der einen oder der mehreren vordefinierten Regionen bezüglich des Bezugspunkts, um eine Tonausgabe zu erzeugen, die Toncharakteristiken aufweist, die mit der Tonentzerrungskategorie assoziiert sind.

2. Vorrichtung nach Anspruch 1, wobei die Benutzerschnittstelle (210) derart ausgelegt ist, dass die Toncharakteristiken der Tonausgabe in einer kontinuierlichen Weise variieren, wenn die erkannte Position kontinuierlich geändert wird.

3. Vorrichtung nach Anspruch 1 oder 2, wobei die Benutzerschnittstelle (210) derart ausgelegt ist, dass die Toncharakteristiken der Tonausgabe in einer diskreten abgestuften Weise variieren, wenn die erkannte Position kontinuierlich geändert wird.

4. Vorrichtung nach einem der vorhergehenden Ansprüche, wobei die eine oder die mehreren vordefinierten Regionen eine Vielzahl von vordefinierten Regionen (211, 212, 213, 214) umfassen, die mit jeweiligen Tonentzerrungskategorien assoziiert sind.

5. Vorrichtung nach Anspruch 4, wobei die Vielzahl von vordefinierten Regionen (211, 212, 213, 214) derart angeordnet ist, dass die mit den jeweiligen Tonentzerrungskategorien assoziierten Toncharakteristiken von einer vordefinierten Region zu einer anderen vordefinierten Region inkrementell variieren.

6. Vorrichtung nach einem der vorhergehenden Ansprüche, wobei die Benutzerschnittstelle (210) einen Positionsindikator (221) zum Anzeigen mindestens einer von der erkannten Position und der absoluten Amplitude des Tonsignals umfasst.

7. Vorrichtung nach Anspruch 6, wobei der Positionsindikator (221) so ausgelegt ist, dass er auf der Auswahlebene (215) positioniert wird, um Steuerung der Tonausgabe zu ermöglichen.

8. Vorrichtung nach Anspruch 6 oder 7, wobei die Vorrichtung so ausgelegt ist, dass sie eine Größe und/oder Form des Positionsindikators (221) erkennt und die absolute Amplitude der Tonausgabe basierend auf der erkannten Größe und/oder Form des Positionsindikators (221) steuert.

9. Vorrichtung nach Anspruch 6 oder 7, wobei die Vorrichtung so ausgelegt ist, dass sie die Auswahlebene (215) erkennt und die Tonausgabe basierend auf der erkannten Auswahlebene (215) steuert.

10. Vorrichtung nach Anspruch 6, wobei die Bezugsposition einer oder mehreren der Folgenden entspricht: einer Standardamplitude, einer früher ausgewählten Amplitude und einer minimalen Amplitude.

11. Vorrichtung nach einem der vorhergehenden Ansprüche, wobei die eine oder die mehreren vordefinierten Regionen (211, 212, 213, 214) einen Tonindikator (223) zum Anzeigen der assoziierten Tonentzerrungskategorie umfassen.

12. Vorrichtung nach einem der vorhergehenden Ansprüche, wobei die eine oder die mehreren vordefinierten Regionen (211, 212, 213, 214) eine oder mehrere vordefinierte Teilregionen (525, 526) umfassen, die jeweilige Tonausgaben definieren, in welchen die Amplitude einer oder mehrerer Frequenzbandbreiten des Tonsignals vordefiniert sind.

13. Vorrichtung nach einem der vorhergehenden Ansprüche, wobei die Vorrichtung so konfiguriert ist, dass sie verhindert, dass die absolute Amplitude des Tonsignals über eine vorbestimmte Sicherheitsgrenze hinaus erhöht wird.

14. Verfahren, umfassend:
Darstellen einer Benutzerschnittstelle für einen Tonentzerrer, wobei die Benutzerschnittstelle eine oder mehrere vordefinierte Regionen (211, 212, 213, 214) umfasst, die eine oder die mehreren vordefinierten Regionen so angeordnet sind, dass sie eine Auswahlebene (215) bilden, und jede Region (211, 212, 213, 214) mit einer Tonentzerrungskategorie assoziiert ist;
Erkennen einer Position einer Benutzereingabe innerhalb der einen oder der mehreren vordefinierten Regionen (211, 212, 213, 214) bezüglich eines Bezugspunkts; und
Steuern einer Amplitude einer oder mehrerer Frequenzbandbreiten und einer absoluten Amplitude eines Tonsignals basierend auf der erkannten Position der Benutzereingabe innerhalb der einen oder der mehreren vordefinierten Regionen bezüglich des Bezugspunkts, um eine Tonausgabe zu erzeugen, die Toncharakteristiken aufweist, die mit der Tonentzerrungskategorie assoziiert sind.

## Revendications

1. Appareil comprenant :
un affichage électronique (630) configuré pour afficher une interface utilisateur (210) pour un égaliseur audio, l'interface utilisateur (210) comprenant une ou plusieurs régions prédéfinies (211, 212, 213, 214), la ou les régions prédéfinies étant conçues pour former un plan de sélection (215) et chaque région (211, 212, 213, 214) étant associée à une catégorie d'égalisation audio ;
l'appareil comprenant en outre un ou plusieurs processeurs (628) configurés pour :
détecter une position d'une entrée d'utilisateur dans la ou les régions prédéfinies par rapport à un point de référence ; et
réguler une amplitude d'une ou de plusieurs largeurs de bande de fréquence et une amplitude absolue d'un signal audio en se basant sur la position détectée de l'entrée d'utilisateur dans la ou les régions prédéfinies par rapport au point de référence afin de produire une sortie audio ayant des caractéristiques audio associées à la catégorie d'égalisation audio.

2. Appareil selon la revendication 1, dans lequel l'interface utilisateur (210) est configurée de telle sorte que les caractéristiques audio de la sortie audio varient de manière continue au fur et à mesure que la position détectée est modifiée en continu.

3. Appareil selon la revendication 1 ou 2, dans lequel l'interface utilisateur (210) est configurée de telle sorte que les caractéristiques audio de la sortie audio varient de manière discrète étape par étape au fur et à mesure que la position détectée est modifiée en continu.

4. Appareil selon l'une quelconque des revendications précédentes, dans lequel la ou les régions prédéfinies comprennent une pluralité de régions prédéfinies (211, 212, 213, 214) associées à des catégories respectives d'égalisation audio.

5. Appareil selon la revendication 4, dans lequel la pluralité de régions prédéfinies (211, 212, 213, 214) sont disposées de telle sorte que les caractéristiques audio associées aux catégories respectives d'égalisation audio varient de manière incrémentielle d'une région prédéfinie à une autre région prédéfinie.

6. Appareil selon l'une quelconque des revendications précédentes, dans lequel l'interface utilisateur (210) comprend un indicateur de position (221) pour indiquer la position détectée et/ou l'amplitude absolue du signal audio.

7. Appareil selon la revendication 6, dans lequel l'indicateur de position (221) est configuré de sorte à être positionné sur le plan de sélection (215) pour permettre une commande de la sortie audio.

8. Appareil selon la revendication 6 ou 7, dans lequel l'appareil est configuré pour détecter une taille et/ou une forme de l'indicateur de position (221) et commande l'amplitude absolue de la sortie audio en se basant sur la taille et/ou la forme détectée de l'indicateur de position (221).

9. Appareil selon la revendication 6 ou 7, dans lequel l'appareil est configuré pour détecter le plan de sélection (215) et commander la sortie audio en se basant sur le plan de sélection (215) détecté.

10. Appareil selon la revendication 6, dans lequel la position de référence correspond à un ou plusieurs éléments suivants : une amplitude par défaut, une amplitude sélectionnée auparavant et une amplitude minimale.

11. Appareil selon l'une quelconque des revendications précédentes, dans lequel la ou les régions prédéfinies (211, 212, 213, 214) comprennent un indicateur audio (223) pour indiquer la catégorie associée d'égalisation audio.

12. Appareil selon l'une quelconque des revendications précédentes, dans lequel la ou les régions prédéfinies (211, 212, 213, 214) comprennent une ou plusieurs sous-régions prédéfinies (525, 526) définissant des sorties audio respectives dans lesquelles l'amplitude d'une ou de plusieurs largeurs de bande de fréquence du signal audio sont prédéfinies.

13. Appareil selon l'une quelconque des revendications précédentes, dans lequel l'appareil est configuré pour empêcher l'augmentation de l'amplitude absolue du signal audio au-delà d'une limite de sécurité prédéterminée.

14. Procédé consistant à :
afficher une interface utilisateur pour un égaliseur audio, l'interface utilisateur comprenant une ou plusieurs régions prédéfinies (211, 212, 213, 214), la ou les régions prédéfinies étant conçues pour former un plan de sélection (215) et chaque région (211, 212, 213, 214) étant associée à une catégorie d'égalisation audio ;
détecter une position d'une entrée d'utilisateur dans la ou les régions prédéfinies (211, 212, 213, 214) par rapport à un point de référence ; et
réguler une amplitude d'une ou de plusieurs largeurs de bande de fréquence et une amplitude absolue d'un signal audio en se basant sur la position détectée de l'entrée d'utilisateur dans la ou les régions prédéfinies par rapport au point de référence afin de produire une sortie audio ayant des caractéristiques audio associées à la catégorie d'égalisation audio.
